# EUROPÄISCHE PATENTANMELDUNG

(11) **EP 4 674 619 A1**
(43) Veröffentlichungstag der Anmeldung: **07.01.2026**
(21) Anmeldenummer: 24185635.0
(22) Anmeldetag: 01.07.2024
(51) Int. Cl.: B32B 17/10, B32B 3/08, B60J 1/00, C03C 4/00, H01L 31/048, H02S 20/00

(54) **PHOTOVOLTAISCHE VERBUNDSCHEIBE ZUR REDUKTION EINER SCHATTENBILDUNG**

(71) Anmelder: Saint-Gobain Sekurit France, 60150 Thourotte (FR)
(72) Erfinder: DEBIEL, Noah Frederik, 52134 Herzogenrath (DE); HAMMOUD, Rayan, 52134 Herzogenrath (DE); WOHLFEIL, Dirk, 52134 Herzogenrath (DE)
(74) Vertreter: SGR Germany-Patents

(57) **Zusammenfassung**

Die vorliegende Erfindung betrifft eine Verbundscheibe (100) zur Reduktion einer Schattenbildung in einem Innenraum, die Verbundscheibe (100) mindestens umfassend in der folgenden Reihenfolge:
- eine Außenscheibe (1) mit einer Außenfläche und einer Innenfläche (I, II), wobei die Außenscheibe (1) eine Glasscheibe mit einem geringen Eisenanteil ist,
- eine äußere Zwischenschicht (3),
- mindestens ein photovoltaisches Bauteil (4), wobei das mindestens eine photovoltaische Bauteil (4) ein photovoltaisches Modul mit einer Mehrzahl miteinander verschalteter photovoltaischer Zellen (4.1) und zwischen diesen photovoltaischen Zellen (4.1) gebildeten Zellzwischenräumen (4.2) ist,
- eine innere Zwischenschicht (5), und
- eine Innenscheibe (2) mit einer Außenfläche und einer Innenfläche (III, IV),
wobei auf einer von der Außenscheibe (1) abgewandten Seite des mindestens einen photovoltaischen Bauteils (4) ein Diffusionselement (9.1, 9.2, 9.3, 9.4) vorgesehen ist, welches von einer Außenseite durch die Außenscheibe (1) eintretende und durch die Zellzwischenräume (4.2) des photovoltaischen Moduls hindurchtretende Strahlung vor Eintritt in den Innenraum diffus bricht.

## Beschreibung

Die Erfindung betrifft eine Verbundscheibe aus Glasscheiben und einem photovoltaischen Bauteil, ein Verfahren zur Herstellung der Verbundscheibe und eine Verwendung der Verbundscheibe.

Es ist allgemein bekannt, dass bei Gebäuden oder im Fahrzeugbereich Verglasungen mit photovoltaischen Bauteilen ausgestattet sein können. Diese Verglasungen sind häufig als Verbundscheiben ausgebildet, umfassend eine Außenscheibe und eine Innenscheibe, die über eine Zwischenschicht miteinander verbunden sind. Bei solchen Verbundscheiben können die photovoltaischen Bauteile in die Zwischenschicht eingelagert werden. Diese photovoltaischen Bauteile sind üblicherweise aus mehreren Modulen gebildet, die jeweils bspw. eine Mehrzahl miteinander verschalteter photovoltaischer Zellen und zwischen diesen photovoltaischen Zellen gebildete Zellzwischenräume umfassen.

Durch die Zwischenräume kann ein gewisser Anteil des auf die photovoltaischen Bauteile fallenden Lichts in den Innenraum gelangen, wodurch der Innenraum insgesamt erhellt wird. Jedoch können auch unerwünschte Schattenmuster entstehen, die bspw. als Linien oder Flächen mit hellen und dunklen Bereichen im Innenraum auftreten und diesen inhomogen beleuchten. Diese inhomogene Beleuchtung kann störend wirken und unerwünschte optische Effekte wie Reflektionen erzeugen. Zudem können bewegte Schattenmuster, welche bspw. durch eine bewegte Lichtquelle außerhalb des Gebäudes oder ein sich relativ zur Lichtquelle bewegendes Fahrzeug entstehen können, bei im Innenraum befindlichen Personen Unwohlsein hervorrufen oder gar deren Gesundheit beeinträchtigen.

Der vorliegenden Erfindung liegt daher die Aufgabe zugrunde, eine verbesserte Verbundscheibe mit mindestens einem integrierten photovoltaischen Bauteil bereitzustellen, die eine unerwünschte Schattenbildung im Innenraum reduziert.

Die Aufgabe der vorliegenden Erfindung wird erfindungsgemäß durch eine Verbundscheibe gemäß Anspruch 1 gelöst. Bevorzugte Ausführungsformen gehen aus den Unteransprüchen hervor. Die Erfindung betrifft auch ein Verfahren zur Herstellung der Verbundscheibe und eine Verwendung der Verbundscheibe als Fahrzeug-Dachscheibe.

Die erfindungsgemäße Verbundscheibe zur Reduktion einer Schattenbildung in einem Innenraum umfasst in der folgenden Reihenfolge mindestens:
- eine Außenscheibe mit einer Außenfläche und einer Innenfläche, wobei die Außenscheibe eine Glasscheibe mit einem geringen Eisenanteil ist,
- eine äußere Zwischenschicht,
- mindestens ein photovoltaisches Bauteil, wobei das mindestens eine photovoltaische Bauteil ein photovoltaisches Modul mit einer Mehrzahl miteinander verschalteter photovoltaischer Zellen und zwischen diesen photovoltaischen Zellen gebildeten Zellzwischenräumen ist,
- eine innere Zwischenschicht, und
- eine Innenscheibe mit einer Außenfläche und einer Innenfläche,
wobei auf einer von der Außenscheibe abgewandten Seite des mindestens einen photovoltaischen Bauteils ein Diffusionselement vorgesehen ist, welches von einer Außenseite durch die Außenscheibe eintretende und durch die Zellzwischenräume des photovoltaischen Moduls hindurchtretende Strahlung vor Eintritt in einen Innenraum diffus bricht.

Mit Außenseite ist im Sinne der Erfindung die zur Außenfläche der Außenscheibe liegende äußere Umgebung gemeint. Die Strahlung, die von der Außenseite durch die Außenscheibe eintritt, ist dazu vorgesehen, mehrheitlich aus Sonnenstrahlung zu bestehen. Entsprechend ist im Sinne der Erfindung mit Innenseite, die zur Innenfläche der Innenscheibe liegende Umgebung, in der Regeln der Innenraum, gemeint.

Die Außenscheibe und die Innenscheibe weisen, wie oben beschrieben, jeweils eine außenseitige Oberfläche, d.h. eine Außenfläche, und eine innenraumseitige Oberfläche, d.h. eine Innenfläche, auf und eine dazwischen verlaufende, umlaufende Seitenkante. Mit Außenfläche wird im Sinne der Erfindung diejenige Hauptfläche bezeichnet, welche dafür vorgesehen ist, in Einbaulage der äußeren Umgebung zugewandt zu sein. Mit Innenfläche wird im Sinne der Erfindung diejenige Hauptfläche bezeichnet, welche dafür vorgesehen ist, in Einbaulage dem Innenraum zugewandt zu sein. Die Innenfläche der Außenscheibe und die Außenfläche der Innenscheibe sind in der erfindungsgemäßen Verbundscheibe einander zugewandt.

Die Oberflächen der Verbundscheibe werden typischerweise wie folgt bezeichnet:
Die Außenfläche der Außenscheibe wird als Seite I bezeichnet. Die Innenfläche der Außenscheibe wird als Seite II bezeichnet. Die Außenfläche der Innenscheibe wird als Seite III bezeichnet. Die Innenfläche der Innenscheibe wird als Seite IV bezeichnet.

Ist die Verbundscheibe dafür vorgesehen, in einer Fensteröffnung eines Fahrzeugs einen Innenraum gegenüber der äußeren Umgebung abzutrennen, so wird mit Innenscheibe im Sinne der Erfindung die dem Innenraum (Fahrzeuginnenraum) zugewandte Scheibe bezeichnet. Mit Außenscheibe wird die der äußeren Umgebung zugewandte Scheibe bezeichnet. Die Verbundscheibe ist besonders bevorzugt eine Fahrzeug-Dachscheibe. Die Verbundscheibe kann aber auch eine Windschutzscheibe, Heckscheibe oder Seitenscheibe eines Fahrzeugs sein.

Darüber hinaus kann die Verbundscheibe auch eine Gebäudeverglasung sein oder Bestandteil einer Gebäudeverglasung sein.

Es versteht sich, dass mit Durchsicht durch die Verbundscheibe die Durchsicht von der äußeren Umgebung aus oder die Durchsicht vom Innenraum aus gemeint ist.

Die Außenscheibe ist erfindungsgemäß eine Glasscheibe mit einem geringen Eisenanteil. Bevorzugt umfasst das Glas der Glasscheibe ein Kalk-Natron-Glas. Das Glas der Glasscheibe kann aber auch aus anderen Glassorten gefertigt sein, bspw. Quarzglas, Borosilikatglas oder Alumino-Silikat-Glas. Die genannten speziellen Glassorten stellen die Basis der Glaszusammensetzung dar, während das Glas der Glasscheibe gemäß der Erfindung einen geringen Eisenanteil aufweist. Das Glas der Glasscheibe ist bevorzugt ein Weißglas (auch als *"ultra clear glass"* oder "ultraklares Glas" bezeichnet). Unter Weißglas wird ein solches Glas verstanden, welches einen integrierten Lichttransmissionsgrad TL für sichtbares Licht (nach ISO 9050:2003) von 90 % oder mehr und einen geringen Eisenanteil aufweist. Bezogen auf die Bestimmung des Lichttransmissionsgrades nach ISO 9050:2003 (siehe Punkt 3.3 in der Norm) kann zur Bestimmung die relative spektrale Verteilung der Lichtart D65 (siehe bspw. ISO 11664-2:2007) und/oder die relative spektrale Verteilung der Lichtart A (siehe bspw. ISO 11664-2:2007) verwendet werden. Mit anderen Worten: der beschriebene Lichttransmissionsgrad-Bereich gilt für die Bestimmung mittels der Lichtart A und/oder der Lichtart D65. Durch die Verwendung von Glas mit dem hohen Lichttransmissionsgrad TL und einem geringen Eisenanteil kann erreicht werden, dass möglichst viel Licht das Glas passieren und auf das mindestens eine photovoltaische Bauteil treffen kann, so dass die Erzeugungseffizienz an elektrischer Energie der Verbundscheibe im Vergleich zu der Verwendung von Glas mit geringerem Lichttransmissionsgrad und höherem Eisenanteil erhöht werden kann.

Gemäß einer bevorzugten Ausführungsform der Erfindung weist das Kalk-Natron-Glas die folgende Glaszusammensetzung, bezogen auf 100 Gew.-% der gesamten Glaszusammensetzung, auf:
- SiOz: 67 bis 75 Gew.-%,
- Na₂O: 10 bis 20 Gew.-%,
- CaO: 5 bis 15 Gew.-%,
- MgO: 0 bis 7 Gew.-%,
- Al₂O₃: 0 bis 5 Gew.-% und
- K₂O: 0 bis 5 Gew.-%

Neben den obengenannten Bestandteilen und Eisen kann das Glas der erfindungsgemäßen Glasscheibe weitere Bestandteile mit einem geringen Anteil aufweisen. Bspw. kann das Glas SO₃ als Läuterungsmittel mit einem Anteil von 0,01 bis 1,0 Gew.-%, Chlorid mit einem Anteil von 0,01 bis 0,03 Gew.-% und TiO₂ mit einem Anteil von 0,001 bis 0,03 Gew.-% aufweisen.

Der Gesamteisenanteil, der in der Glasmasse bzw. im resultierenden Glas vorhanden ist, wird hier in Übereinstimmung mit der Standardpraxis als Fe₂O₃ ausgedrückt. Dies bedeutet jedoch nicht, dass das gesamte Eisen tatsächlich in der Form von Fe₂O₃ vorliegt. Ebenso wird der Fe²⁺-Anteil hier als FeO angegeben, auch wenn möglicherweise nicht das gesamte Eisen im Zustand Fe²⁺ in der Glasmasse bzw. im resultierenden Glas in Form von FeO vorliegt. Eisen ist im Zustand Fe²⁺ (FeO) ein blaugrüner Farbstoff, während Eisen im Zustand Fe³⁺ (Fe₂O₃) ein gelbgrüner Farbstoff ist. Insbesondere die durch Fe²⁺ verursachte blaugrüne Färbung des Glases sollte vorteilhafterweise vermieden werden, um ein Glas mit einer neutralen oder klaren Farbe zu erreichen. Durch die Verwendung von Glasscheiben mit einem geringen Eisenanteil für die Außenscheibe kann eine Verbundscheibe mit ultraklaren Glasscheiben erreicht werden, in der möglichst viel Licht von der Außenseite der Verbundscheibe auf das mindestens eine photovoltaische Bauteil treffen kann. Dies ist besonders vorteilhaft, wenn das mindestens eine photovoltaische Bauteil ein photovoltaisches Modul mit einer Mehrzahl miteinander verschalteter photovoltaischer Zellen umfasst, wobei die photovoltaischen Zellen bifaziale photovoltaische Zellen sind. Dadurch kann insgesamt mehr elektrische Energie durch das mindestens eine photovoltaische Bauteil im Vergleich zur Verwendung von Glasscheiben mit geringerer Klarheit erzeugt werden.

Der Begriff "Glasscheibe mit einem geringen Eisenanteil" ist dem Fachmann bekannt. Insbesondere wird unter "Glasscheibe mit einem geringen Eisenanteil" eine solche Glasscheibe verstanden, die keine, für das menschliche Auge wahrnehmbare, Färbung, die durch Eisen bedingt ist, aufweist. Bevorzugt weist die Glasscheibe mit einem geringen Eisenanteil einen Gesamteisenanteil, ausgedrückt in der Form von Fe₂O₃, von 0,020 Gew.-% oder weniger, weiter bevorzugt von 0,015 Gew.-% oder weniger, noch weiter bevorzugt von 0,012 Gew.-% oder weniger, bezogen auf 100 Gew.-% der gesamten Glaszusammensetzung, auf. Alternativ oder in Kombination mit dem vorgenannten weist die Glasscheibe mit einem geringen Eisenanteil einen Fe²⁺-Anteil, ausgedrückt in der Form von FeO, von 0,0030 Gew.-% oder weniger, weiter bevorzugt von 0,0025 Gew.-% oder weniger, noch weiter bevorzugt von 0,0024 Gew.-% oder weniger, bezogen auf 100 Gew.-% der gesamten Glaszusammensetzung, auf.

Bevorzugt ist die Glasscheibe mit einem geringen Eisenanteil eine Glasscheibe auf Basis von dem oben definierten Kalk-Natron-Glas mit der speziellen Glaszusammensetzung und mit den oben definierten speziellen Eisenanteilen.

Die Außenscheibe und die Innenscheibe sind bevorzugt gebogen, das heißt sie weisen eine Krümmung auf, wobei typische Krümmungsradien im Bereich von etwa 10 cm bis etwa 40 m liegen. Die Innenfläche der Innenscheibe der Verbundscheibe ist dabei in der Regel konkav gekrümmt.

Die Dicken der Außenscheibe und der Innenscheibe betragen unabhängig voneinander bevorzugt von 0,5 mm bis 5 mm, besonders bevorzugt von 1 mm bis 3 mm.

Die Außenscheibe und die Innenscheibe können optional unabhängig voneinander thermisch oder chemisch vorgespannt, teilvorgespannt oder nicht vorgespannt sein.

Die Außenscheibe weist (mindestens) einen transparenten Bereich auf, der im Sinne der Erfindung als "Durchsichtsbereich" bezeichnet wird. Im transparenten Durchsichtsbereich kann Sonnenlicht durch die Außenscheibe hindurchtreten und das mindestens eine photovoltaische Bauteil anregen. Der transparente Durchsichtsbereich der Außenscheibe definiert daher einen aktiven Bereich der Verbundscheibe. Damit ist gemeint, dass in Draufsicht auf die Verbundscheibe der transparente Bereich der Außenscheibe und der aktive Bereich deckungsgleich sind. Das mindestens eine photovoltaische Bauteil ist (zumindest teilweise, insbesondere größtenteils oder sogar vollständig) im Durchsichtsbereich angeordnet.

Die Außenscheibe kann insgesamt transparent ausgebildet sein, sodass der Durchsichtsbereich die gesamte Außenscheibe umfasst. Dann bildet die gesamte Verbundscheibe den aktiven Bereich. Die Außenscheibe kann aber auch einen opaken Maskierungsbereich aufweisen, durch den kein Sonnenlicht treten kann und der einen Maskierungsbereich der Verbundscheibe definiert. Der aktive Bereich entspricht dann der Verbundscheibe abzüglich des Maskierungsbereichs. Solche Maskierungsbereiche sind bei Fahrzeugscheiben üblich. Sie werden typischerweise durch einen opaken Abdeckdruck auf der Innenfläche der Außenscheibe ausgebildet. Dabei wird eine Emaille-Druckpaste, welche Glasfritten und ein Pigment, insbesondere Schwarzpigment, enthält, bspw. im Siebdruckverfahren auf die Oberfläche aufgedruckt und anschließend eingebrannt. Der Maskierungsbereich umfasst typischerweise einen umlaufenden Randbereich der Außenscheibe, der einen zentralen Durchsichtsbereich rahmenartig umgibt. Der Maskierungsbereich kann aber auch weitere Bereiche umfassen, welche bspw. als eine Art von Querverstrebungen des rahmenartigen Randbereichs ausgebildet sind.

Ein Maskierungsbereich kann alternativ auch dadurch ausgebildet sein, dass die zwischen dem mindestens einen photovoltaischen Bauteil und der Außenscheibe befindliche äußere Zwischenschicht teilweise opak ausgebildet ist oder eine opake Folie oder Platte zwischen dem mindestens einen photovoltaischen Bauteil und der Außenscheibe in der Verbundscheibe eingelagert ist. Auch dann kann im Maskierungsbereich kein Sonnenlicht auf das mindestens eine photovoltaische Bauteil treffen. In diesem Falle wird der aktive Bereich der Verbundscheibe ebenfalls verkleinert, obwohl die Außenscheibe insgesamt transparent ausgebildet ist. Das vorstehend Ausgeführte gilt entsprechend.

Erfindungsgemäß umfasst die Verbundscheibe eine äußere Zwischenschicht und eine innere Zwischenschicht. Diese haben die Aufgabe, die Bestandteile der Verbundscheibe, zwischen denen sie angeordnet sind, adhäsiv miteinander zu verbinden. Insbesondere dienen diese der flächigen Verbindung zwischen der äußeren Außenscheibe, dem mindestens einen photovoltaischen Bauteil und der Innenscheibe.

Erfindungsgemäß umfasst die Verbundscheibe das mindestens eine photovoltaische Bauteil. Ein "photovoltaisches Bauteil" ist im Sinne der Erfindung ein einstückiges elektrisches Bauelement zur Gewinnung von elektrischer Energie bzw. elektrischem Strom mittels des photovoltaischen Effekts. Das photovoltaische Bauteil wird als einzelnes Bauelement gehandhabt und verfügt bevorzugt über nur zwei elektrische Anschlüsse (zwei elektrische Pole, gleichsam "Plus- und Minus-Pol"), über welche das Bauteil als Ganzes elektrisch kontaktiert wird. Das photovoltaische Bauteil kann auch als "Photovoltaikelement" oder "Solarelement" bezeichnet werden. Weist die Verbundscheibe eine Mehrzahl photovoltaischer Bauteile auf, so sind bevorzugt sämtliche photovoltaische Bauteile in derselben Ebene bzw. Lage der Verbundscheibe angeordnet. Sämtliche photovoltaische Bauteile weisen dann (zumindest näherungsweise) denselben Abstand zur Außenscheibe bzw. zur Innenscheibe auf. In einer bevorzugten Ausführungsform der Erfindung umfasst die Verbundscheibe eine Mehrzahl photovoltaischer Bauteile.

Das erfindungsgemäße mindestens eine photovoltaische Bauteil umfasst ein photovoltaisches Modul mit einer Mehrzahl miteinander verschalteter photovoltaischer Zellen. Eine "photovoltaische Zelle" im Sinne der Erfindung ist die kleinstmögliche photovoltaische Einheit und strukturell nicht weiter unterteilt. Das mindestens eine photovoltaische Bauteil, genauer gesagt dessen photovoltaische Zellen, sind geeignet, Sonnenlicht direkt in elektrische Energie umzuwandeln. Im Rahmen der vorliegenden Erfindung können im Prinzip sämtliche Arten von photovoltaischen Bauteilen bzw. photovoltaischen Zellen, bspw. mono- oder bifaziale Zellen, verwendet werden. Es liegen keine Einschränkungen auf bestimmte photovoltaische Zellen vor.

Diese photovoltaischen Zellen sind im Allgemeinen opak, d.h. weisen einen Lichttransmissionsgrad TL nach ISO 9050:2003 (Bestimmung mittels der Lichtart A und/oder der Lichtart D65) für sichtbares Licht von weniger als 30 %, bevorzugt weniger als 25 %, besonders bevorzugt weniger als 5 %, insbesondere 0 %, auf. Mit "sichtbarem Licht" ist Licht mit einer Wellenlänge von 380 nm bis 780 nm gemeint. Bevorzugt umfasst das photovoltaische Modul eine Mehrzahl seriell miteinander verschalteter photovoltaischer Zellen, die in einem Strang angeordnet sind, der sich in eine Richtung erstreckt. Zwischen jeweils benachbarten photovoltaischen Zellen ist ein Zellzwischenraum ausgebildet, welcher es ermöglicht, die für sich genommen ebenen photovoltaischen Zellen in einer gekrümmten Verbundscheibe anzuordnen. Der hierfür benötigte und als Zwischenraum zwischen den photovoltaischen Zellen sichtbare Abstand beträgt bspw. höchstens 5 cm, 2 cm, 1 cm oder 5 mm, mit möglichen Untergrenzen (hiervon unabhängig) bei 0,5 mm, 1 mm, 1,5 mm oder 2 mm. Zudem kann der Zellzwischenraum, sofern im aktiven Bereich auch der Maskierungsbereich ausgebildet ist, auch als ein Zwischenraum zwischen (in der Draufsicht) dem Maskierungsbereich und den diesem Maskierungsbereich unmittelbar nächstbenachbart liegenden photovoltaischen Bauteilen verstanden werden, wobei bevorzugt kein Zwischenraum zwischen Maskierungsbereich und photovoltaischem Bauteil ausgebildet ist; diese in der Draufsicht also überlappen.

Das mindestens eine photovoltaische Bauteil kann optional von einer thermoplastischen Lage umgeben sein, welche im Sinne der Erfindung auch als "Kapsellage" bezeichnet wird. Die Kapsellage ist insbesondere rahmenartig ausgebildet und in einem umlaufenden Randbereich der Verbundscheibe angeordnet, wobei das mindestens eine photovoltaische Bauteil gleichsam in die rahmenartige Kapselschicht eingesetzt ist. Die Kapsellage weist mindestens eine Aussparung auf, in welche das mindestens eine photovoltaische Bauteil eingesetzt ist. Die Kapsellage kann durch eine thermoplastische Folie (oder mehrere übereinander gestapelte thermoplastische Folien) gebildet werden, in welche die Aussparung durch Ausschneiden eingebracht worden ist. Alternativ kann die Kapsellage auch aus mehreren thermoplastischen Folienabschnitten um das mindestens eine photovoltaische Bauteil zusammengesetzt sein. Die thermoplastische Folie der Kapsellage kann entsprechend der thermoplastischen Folie der ersten thermoplastischen Lage und der zweiten thermoplastischen Lage gewählt werden. Die Kapsellage weist bevorzugt etwa die gleiche Dicke auf wie das mindestens eine photovoltaische Bauteil. Dadurch wird der lokale Dickenunterschied, der durch das örtlich begrenzte, mindestens eine photovoltaische Bauteil eingebracht wird, kompensiert, sodass Lufteinschlüsse vermieden werden, Glasbruch beim Laminieren vermieden werden kann und ein verbessertes optisches Erscheinungsbild entsteht. Sind mehrere photovoltaische Bauteile vorhanden, welche den aktiven Bereich der Verbundscheibe nur teilweise abdecken, so ist die Kapsellage bevorzugt auch in den nicht mit photovoltaischen Bauteilen versehenen Bereichen angeordnet.

Erfindungsgemäß ist auf einer von der Außenscheibe abgewandten Seite des mindestens einen photovoltaischen Bauteils das Diffusionselement vorgesehen, welches von der Außenseite durch die Außenscheibe eintretende und durch die Zellzwischenräume des photovoltaischen Moduls hindurchtretende Strahlung vor Eintritt in den Innenraum diffus bricht. Hierfür ist das Diffusionselement zumindest abschnittsweise im Bereich der darüberliegenden Zellzwischenräume unter diesen ausgebildet, wobei sich Angaben wie "darüber" oder "darunter" jeweils auf den fertig montierten Zustand der Verbundscheibe in einer Anordnung als Schichtstapel beziehen. Vereinfacht sind die Begriffe "darüber" bzw. "darunter" in Bezug auf den fertigen Schichtstapel zu verstehen und meinen "näher an der Außenseite" (darüber) bzw. "näher an der Innenseite" (darunter) als ein jeweiliges Element. Im bevorzugten Fall der Fahrzeug-Dachscheibe beziehen sich diese Begriffe auf den horizontalen Montagezustand der Dachscheibe im Fahrzeug, wobei "darüber" bzw. "darunter" hierbei als "weiter oben" (darüber) bzw. "weiter unten" (darunter) im Schichtstapel zu verstehen sind. Mit dem als Bestandteil der Verbundscheibe vorgesehenen Diffusionselement wird demnach optische Strahlung, insbesondere sichtbares Licht, vor dessen Eintritt in den Innenraum diffus gebrochen. Hierbei werden die vor Eintritt in das Diffusionselement im Wesentlichen parallel verlaufenden Lichtstrahlen derart in dem Diffusionselement abgelenkt, dass die Lichtstrahlen bei Eintritt in den Innenraum in einer Vielzahl voneinander abweichender Raumrichtungen verlaufen.

Es wird nämlich das durch das Diffusionselement tretende sichtbare Licht von diesem zu einem gewissen Grad gestreut, wobei dieser Grad auch als "Haze" bzw. "Transmissions-Haze" bezeichnet wird. Der Haze des Diffusionselements wird in Prozent angegeben und entspricht einem Quotienten aus (jeweils auf dieselbe Fläche bezogen) gestreutem Licht und durchgelassenem (d.h. ungestreut durch das Diffusionselement hindurchtretendem) Licht. Der Haze kann mittels der in ASTM D1003 mit Lichtquelle C und/oder DIN EN ISO 13468 Teile 1 und 2 mit Lichtquelle D65 beschriebenen Versuchsaufbauten und -verfahren (in analoger Anwendung für Glasscheiben), oder bspw. mit einem Transmissions-Haze-Messgerät, ermittelt werden. Vereinfacht gesagt ist der Haze also ein Maß dafür, wie stark das sichtbare Licht, das durch das Diffusionselement hindurchtritt, in gegenüber einer Eintrittsrichtung abweichende Richtungen gestreut wird, anstatt in Eintrittsrichtung hindurchzutreten.

Bevorzugt beträgt der Haze des Diffusionselements (zumindest im Bereich darüberliegender Zellzwischenräume) mindestens 10 %, besonders bevorzugt mindestens 20 %, 30 % oder 50 % (mit möglichen und hiervon unabhängigen Obergrenzen bei 80 %, 70 % oder 60 %). Das in den Innenraum eintretende Licht ist somit im Wesentlichen ungerichtet und leuchtet diesen blendfrei aus, bspw. liegt im Innenraum in grober Näherung eine Lambert-Verteilung der hindurchtretenden Lichtstrahlen vor. Diese (gegenüber einer Verbundscheibe ohne Diffusionselement) weniger stark gerichtete und somit gleichmäßigere Ausleuchtung des Innenraums, die bevorzugt frei von Licht- und Schattenmustern ist, verbessert den Komfort der Personen im Innenraum.

In einer bevorzugten Ausführungsform deckt das Diffusionselement mindestens 80 %, bevorzugt mindestens 90 % oder 95 %, besonders bevorzugt 100 %, der innerhalb des Durchsichtsbereichs der Verbundscheibe liegenden Zellzwischenräume ab. Dies bedeutet, dass das Diffusionselement derart unter den darüberliegenden Zellzwischenräumen angeordnet ist, dass in einer Projektion auf eine durch eine größte räumliche Ausdehnung der Verbundscheibe definierte Ebene mindestens 80 % bzw. 90 % bzw. 95 % oder 100 % einer durch die Zellzwischenräume gebildeten Projektionsfläche von dem Diffusionselement abgedeckt sind. Vereinfacht gesagt sind also 80 % bzw. 90 % bzw. 95 % oder 100 % der durch die Zellzwischenräume gebildeten Fläche in einer Draufsicht von der Innenseite her durch das Diffusionselement abgedeckt. Durch die bevorzugte Abdeckung der Zellzwischenräume durch das Diffusionselement wird die Bildung von Schattenmustern im Innenraum (zumindest im Bereich der abgedeckten Zellzwischenräume) vermieden, sodass in diesem Bereich der Komfort der Personen im Innenraum verbessert wird.

In einer bevorzugten Ausführungsform weist das Diffusionselement zumindest im Bereich darüberliegender Zellzwischenräume einen Lichttransmissionsgrad TL nach ISO 9050:2003 (Bestimmung mittels der Lichtart A und/oder der Lichtart D65) von mindestens 90 %, bevorzugt mindestens 92 %, 94 %, 96 %, 97 % oder 98 % auf, wobei mögliche Obergrenzen (davon unabhängig) bei höchstens 99,9 %, 99,5 % oder 99 % liegen können. Dadurch werden für die Personen im Innenraum angenehme Lichtverhältnisse geschaffen, da das von der Außenseite durch die Außenscheibe einfallende und von dem Diffusionselement gefilterte Licht letzteres größtenteils passiert und somit zur homogenen Ausleuchtung des Innenraums zur Verfügung steht.

Bevorzugt sind die äußere Zwischenschicht und die innere Zwischenschicht jeweils unabhängig voneinander auf Basis von Polyvinylbutyral (PVB), Polyolester (POE), Ethylen-Vinylacetat (EVA) oder Polyurethan (PU) ausgebildet oder aus Gemischen oder Copolymeren oder Derivaten davon, besonders bevorzugt auf Basis von PVB. Damit ist gemeint, dass die Zwischenschicht größtenteils das besagte Polymer enthält (Anteil größer als 50 Gew.-%). Die Zwischenschicht kann außer dem Polymer weitere Zusätze enthalten, bspw. Weichmacher, UV-Absorber, Stabilisatoren und/oder einen Farbstoff. Wenn ein Farbstoff in der Zwischenschicht enthalten ist, wird diese als "gefärbt" bezeichnet. Eine gefärbte Zwischenschicht weist eine im Vergleich zu einer klaren Zwischenschicht geringeren Lichttransmissionsgrad TL auf. Jede Zwischenschicht ist bevorzugt aus mindestens einer thermoplastischen Folie ausgebildet. Die Dicke jeder thermoplastischen Folie beträgt bevorzugt von 0,2 mm bis 1 mm. Bspw. können PVB-Folien mit den Standarddicken von 0,38 mm oder 0,76 mm verwendet werden.

In einer bevorzugten Ausführungsform sind die äußere Zwischenschicht und die innere Zwischenschicht jeweils aus einer klaren thermoplastischen Folie ausgebildet. Dies bedeutet, dass in dieser Ausführungsform die äußere Zwischenschicht und die innere Zwischenschicht nicht gefärbt sind. Bevorzugt weist die äußere Zwischenschicht und/oder die innere Zwischenschicht einen Lichttransmissionsgrad TL nach ISO 9050:2003 (Bestimmung mittels der Lichtart A und/oder der Lichtart D65) von mindestens 90 %, besonders bevorzugt mindestens 92 %, 94 %, 96 %, 98 %, 99,0 %, 99,5 % oder 99,9 %, auf. Dadurch kann möglichst viel Licht von beiden Seiten der Verbundscheibe auf das mindestens eine photovoltaische Bauteil treffen. Dies ist besonders vorteilhaft, wenn das mindestens eine photovoltaische Bauteil ein photovoltaisches Modul mit einer Mehrzahl miteinander verschalteter photovoltaischer Zellen umfasst, wobei die photovoltaischen Zellen bifaziale photovoltaische Zellen sind. Dadurch kann insgesamt mehr elektrische Energie im Vergleich zur Verwendung von Zwischenschichten, die aus gefärbten thermoplastischen Folien ausgebildet sind, durch das mindestens eine photovoltaische Bauteil erzeugt werden. Bevorzugt sind die äußere Zwischenschicht und die innere Zwischenschicht jeweils aus einer klaren PVB-Folie ausgebildet.

In einer bevorzugten Ausführungsform ist die äußere Zwischenschicht aus einer klaren thermoplastischen Folie ausgebildet und die innere Zwischenschicht aus einer gefärbten thermoplastischen Folie ausgebildet. Im Fall der gefärbten thermoplastischen Folie weist die innere Zwischenschicht bevorzugt einen Lichttransmissionsgrad TL nach ISO 9050:2003 (Bestimmung mittels der Lichtart A und/oder der Lichtart D65) von höchstens 50%, besonders bevorzugt höchstens 40 %, 30 %, 10 % oder 5 % auf. Dadurch werden für die im Innenraum befindliche Person angenehme Lichtverhältnisse geschaffen, da zwischen einzelnen photovoltaischen Zellen durchtretendes Licht vor Eintritt in den Innenraum durch die gefärbte thermoplastische Folie abgedunkelt wird. Zudem wird der thermische Komfort für die im Innenraum befindliche Person durch die Verwendung einer gefärbten thermoplastischen Folie verbessert. Diese Ausführungsform ist besonders vorteilhaft, wenn das mindestens eine photovoltaische Bauteil ein photovoltaisches Modul mit einer Mehrzahl miteinander verschalteter photovoltaischer Zellen umfasst, wobei die photovoltaischen Zellen monofaziale photovoltaische Zellen sind, da dann ein Einfangen des Lichts durch das mindestens eine photovoltaische Bauteil von der Innenraumseite nicht nötig ist. Bevorzugt ist die äußere Zwischenschicht aus einer klaren PVB-Folie ausgebildet und die innere Zwischenschicht aus einer gefärbten PVB-Folie ausgebildet.

Die gefärbte thermoplastische Folie weist einen Farbstoff, vorzugsweise grau, auf. Dementsprechend weist die gefärbte PVB-Folie einen Farbstoff auf. Bei dem Farbstoff kann es sich bspw. um eine Tinte oder ein Farbpigment handeln. Ein Vorteil von insbesondere organischen Tinten gegenüber insbesondere anorganischen Pigmenten ist deren einfachere Verteilbarkeit. Jedoch sind organische Tinten nicht so stabil wie anorganische Pigmente und altern schneller. Anorganische Pigmente agglomerieren allerdings eher als organische Tinten. Dem Fachmann sind für den jeweiligen Anwendungsfall geeignete Tinten oder Farbpigmente bekannt, so dass darauf im Folgenden nicht näher eingegangen wird.

Gemäß einer alternativen Ausführungsform sind die äußere Zwischenschicht und die innere Zwischenschicht optisch klare Kleber, sogenannte optical clear adhesives (OCA). Dem Fachmann sind geeignete optische klare Kleber bekannt.

In einer bevorzugten Ausführungsform ist das Diffusionselement an der Außenfläche und/oder der Innenfläche der Innenscheibe als texturierte Oberfläche der Außenfläche bzw. Innenfläche ausgebildet. Eine "texturierte Oberfläche" bezeichnet im Kontext dieser Erfindung eine spezifisch, bspw. mittels chemischer Ätzverfahren oder durch eine Laserbearbeitung, hergestellte raue und bevorzugt unregelmäßige Oberflächenstruktur der jeweiligen Oberfläche, in welcher das einfallende Licht diffus gebrochen wird. Eine Rauheit der texturierten Oberfläche kann bspw. gemäß ISO 10110-8:2019 ermittelt werden. Bevorzugt beträgt ein Politurgrad der texturierten Oberfläche den Wert P1 gemäß der Norm, d.h. es weist die texturierte Oberfläche weniger als 400 und mindestens 80 Mikrodefekte pro 10 mm Probenlänge auf, wobei die Oberflächenrauheit Rq mittels der quadratischen Mittelwertmethode (engl. "root mean square") der Norm bestimmt wird.

Die Ausgestaltung des Diffusionselements als Bestandteil der Innenscheibe ermöglicht es, die Herstellung der texturierten Oberfläche bspw. in den Fertigungsprozess der Innenscheibe zu integrieren oder an diesen anzuschließen, sodass die übrigen Schritte zur Herstellung der Verbundscheibe hiervon unbeeinträchtigt bleiben. Zudem beseitigt oder überdeckt die texturierte Oberfläche etwaige, vor ihrer Aufbringung an der Außenfläche bzw. Innenfläche vorhandene Unregelmäßigkeiten, sodass auch Gläser mit geringeren Oberflächengüten in der erfindungsgemäßen Verbundscheibe zum Einsatz kommen können. Zudem kann durch die Integration der texturierten Oberfläche in die Innenscheibe deren Materialstärke unverändert bleiben, sodass eine derart gebildete Verbundscheibe hinsichtlich Gesamtdicke und Gewicht vorteilhaft ist.

In einer bevorzugten Ausführungsform ist das Diffusionselement an der Außenfläche und/oder der Innenfläche der Innenscheibe als Aufbringschicht ausgebildet. Eine "Aufbringschicht" bezeichnet im Kontext dieser Erfindung eine dünne Beschichtung aus einem Material, die bevorzugt durch Aufdampfen, vorzugsweise unter Vakuum, auf die Oberfläche die Außen- und/oder Innenfläche der Innenscheibe aufgebracht wird. Die Aufbringschicht kann nach einem CVD-(Chemical Vapour Deposition)-Verfahren oder auch nach einem PVD-(Physical Vapour Deposition)- Verfahren aufgebracht sein. Die Aufbringschicht weist eine Mindestdicke von 2 nm, 5 nm oder 10 nm auf, mit möglichen Höchstdicken (hiervon unabhängig) von 600 nm, 400 nm, 200 nm, 100 nm oder 50 nm. Die Ausgestaltung des Diffusionselements als Aufbringschicht ermöglicht es, diese in den Fertigungsprozess der Innenscheibe zu integrieren oder an diesen anzuschließen. Zudem ist die Verwendung der Aufbringschicht hinsichtlich des Gewichts der hieraus gebildeten Verbundscheibe vorteilhaft. Alternativ kann die Aufbringschicht auch als Flüssig-Beschichtung, bspw. mittels Spinn-Coating auf die Außenfläche und/oder der Innenfläche der Innenscheibe aufgebracht werden, wobei in diesem Fall mögliche Höchstdicken bis zu 10 µm betragen können (unter Beibehaltung der vorgenannten Mindestdicken).

In einer bevorzugten Ausführungsform ist das Diffusionselement eine diffusive Folie, welche zwischen der inneren Zwischenschicht und der Außenfläche der Innenscheibe angeordnet ist. Die diffusive Folie hat hierbei eine Mindestdicke von 10 µm, 12 µm oder 15 µm, mit möglichen Höchstdicken (hiervon unabhängig) von 1 mm, 0,5 mm oder 0,2 mm. Die diffusive Folie kann bspw. aus Polyethylenterephthalat (PET), Polyvinylbutyral (PVB), Polyolester (POE) oder Ethylen-Vinylacetat (EVA) hergestellt sein. Hierbei ist zwischen der diffusiven Folie und der Außenfläche der Innenscheibe bevorzugt eine Klebeschicht vorgesehen. Die Ausgestaltung des Diffusionselements als Folie ermöglicht es, diese bspw. im Laminationsverfahren zwischen der inneren Zwischenschicht und der Außenfläche der Innenscheibe anzuordnen und mit diesen zu verbinden. Hierdurch kann zuverlässig eine flächige Verbindung zwischen der Folie und den die Folie umgebenden Schichten hergestellt und zudem bspw. die mechanische Stabilität des Schichtaufbaus verbessert werden.

In einer bevorzugten Ausführungsform ist das Diffusionselement eine diffusive Folie, welche als Zweischichtfolie integral mit der inneren Zwischenschicht gebildet ist. Eine "Zweischichtfolie" bezeichnet im Kontext dieser Erfindung eine Folie, die aus zwei voneinander verschiedenen Materialien hergestellt ist. Von diesen zwei Schichten bildet eine das Diffusionselement, das die vorgenannten diffusiven Eigenschaften aufweist, und die andere die innere Zwischenschicht, Diese Zweischichtfolie hat insgesamt eine Mindestdicke von 0,2 mm, mit möglichen Höchstdicken (hiervon unabhängig) von 2 mm, 1 mm oder 0,5 mm. Diejenige Schicht der Folie, die das Diffusionselement bildet, ist (wie vorstehend beschrieben) aus Polyethylenterephthalat (PET), Polyvinylbutyral (PVB), Polyolester (POE) oder Ethylen-Vinylacetat (EVA) hergestellt. Diejenige Schicht, die die innere Zwischenschicht bildet, ist (wie in Bezug auf die innere Zwischenschicht erläutert) bevorzugt auf Basis von Polyvinylbutyral (PVB), Polyolester (POE), Ethylen-Vinylacetat (EVA) oder Polyurethan (PU) ausgebildet oder aus Gemischen oder Copolymeren oder Derivaten davon, besonders bevorzugt auf Basis von EVA. Die Integration von diffusiver Folie und innerer Zwischenschicht in der Zweischichtfolie erhöht deren mechanische Stabilität (insbesondere im bevorzugten Fall einer inneren Zwischenschicht aus EVA) und ermöglicht es zudem, die Einbringung des Diffusionselements fertigungstechnisch in einen Verfahrensschritt mit der Herstellung des photovoltaischen Bauteils zu integrieren. Hierdurch wird die Herstellung der Verbundscheibe vereinfacht und es kann eine verbesserte mechanische Stabilität der Verbundscheibe erreicht werden.

In einer bevorzugten Ausführungsform weist die diffusive Folie zudem diffraktive Bereiche auf. Unter "diffraktiven Bereichen" sind im Kontext dieser Anmeldung Bereiche der Folie zu verstehen, in denen das Licht zusätzlich durch gezielte Diffraktion, d.h. Beugung an einem in der Folie gelegenen und spezifisch ausgestalteten Hindernis, abgelenkt werden. Diese diffraktiven Bereiche ermöglichen es, das einfallende Licht bspw. spektral in seine Grundfarben aufzuspalten oder bspw. Logos in den Innenraum zu projizieren. Die Verwendung von diffraktiven Bereichen kann insbesondere mit einer farbigen Ausgestaltung der inneren Zwischenschicht vorteilhaft sein, da sich hierdurch bspw. eine mehrfarbige Beleuchtung mit integrierten Logos erzielen lässt.

In einer bevorzugten Ausführungsform umfasst die Verbundscheibe weiter eine emissivitätsmindernde Beschichtung, die auf der Innenfläche der Innenscheibe angeordnet ist. Emissivitätsmindernde Beschichtungen sind auch als Wärmestrahlung reflektierende Beschichtungen, Beschichtungen niedriger Emissivität oder LowE-Beschichtungen (low emissivity) bekannt. Mit Emissivität wird das Maß bezeichnet, welches angibt, wie viel Wärmestrahlung die Verbundscheibe in Einbaulage im Vergleich zu einem idealen Wärmestrahler (einem schwarzen Körper) in einen Innenraum abgibt. Emissivitätsmindernde Beschichtungen haben die Funktion, die Einstrahlung von Wärme in den Innenraum zu vermeiden (IR-Anteile der Sonnenstrahlung und insbesondere die thermische Strahlung der Verbundscheibe selbst) und ebenso die Abstrahlung von Wärme aus dem Innenraum heraus. Sie weisen reflektierende Eigenschaften gegenüber infraroter Strahlung auf, insbesondere gegenüber Wärmestrahlung im Spektralbereich von 5 µm bis 50 µm (vgl. auch Norm DIN EN 12898:2019-06). Dadurch wird der thermische Komfort im Innenraum wirkungsvoll verbessert. Die emissivitätsmindernden Beschichtungen können bei hohen Außentemperaturen und Sonneneinstrahlung die von der gesamten Verbundscheibe in Richtung des Innenraums abgestrahlte Wärmestrahlung zumindest teilweise reflektieren. Bei niedrigen Außentemperaturen können sie die aus dem Innenraum abgestrahlte Wärmestrahlung reflektieren und somit die Wirkung der kalten Verbundscheibe als Wärmesenke verringern. Durch die emissivitätsmindernde Beschichtung wird der thermische Komfort im Innenraum weiter erhöht.

Die emissivitätsmindernde Beschichtung ist typischerweise ein transparenter Stapel von Dünnschichten. Die emissivitätsmindernde Beschichtung weist mindestens eine, bevorzugt genau eine, elektrisch leitfähige Schicht auf, welche die IR-reflektierenden Eigenschaften bereitstellt. Die leitfähige Schicht ist bevorzugt auf Basis eines transparenten leitfähigen Oxids (TCO, transparent conductive oxide) ausgebildet, insbesondere Indium-Zinn-Oxid (ITO, *indium tin oxide*), alternativ Indium-Zink-Mischoxid (IZO), Gallium-dotiertes Zinnoxid (GZO), Fluordotiertes Zinnoxid (FTO, SnO₂:F), Antimon-dotiertes Zinnoxid (ATO, SnO₂:Sb) oder Niobdotiertes Titanoxid (TiOz:Nb). Im Gegensatz zu Metallen sind TCOs nicht korrosionsanfällig, so dass sie auf der exponierten Innenfläche der Innenscheibe eingesetzt werden können. Außer der leitfähigen Schicht weist die Beschichtung typischerweise dielektrische Schichten auf (bspw. auf Basis von Siliziumoxid oder -nitrid), die insbesondere der Optimierung der optischen Eigenschaften (bspw. Lichttransmission) dienen oder als Barriereschichten zur Regulierung von Sauerstoffdiffusion bei der Abscheidung der Beschichtung dienen.

In Ausführungsformen der vorstehend beschriebenen bevorzugten Konfigurationen besteht die Verbundscheibe strukturell jeweils nur aus den angegebenen Elementen. Die Außenscheibe, die Innenscheibe, die äußere Zwischenschicht und/oder die innere Zwischenschicht können darüber hinaus mit fachüblichen Beschichtungen oder Aufdrucken ausgestattet sein.

Die Verbundscheibe kann plan sein oder auch zylindrisch oder sphärisch gebogen. Insbesondere bei Fahrzeugscheiben für Personenkraftwagen sind sphärisch gebogene Verbundscheiben üblich.

Alle außenseitig des mindestens einen photovoltaischen Bauteils angeordneten Lagen sind bevorzugt klar, d.h. ohne Färbungen, so dass das Sonnenlicht möglichst ungehindert auf das mindestens eine photovoltaische Bauteil treffen kann. Sie weisen bevorzugt einen Lichttransmissionsgrad TL von mindestens 70 % auf, besonders bevorzugt mindestens 80 %, ganz besonders bevorzugt mindestens 90 % (ISO 9050:2003). Dies gilt insbesondere für die Außenscheibe und die äußere Zwischenschicht, über welche das mindestens eine photovoltaischen Bauteil mit der Außenscheibe verbunden ist. Der Lichttransmissionsgrad TL der ersten Zwischenschicht bezieht sich auf die Eigenschaft der ersten Zwischenschicht im laminierten Zustand, d.h. in der fertigen Verbundscheibe. Die Außenscheibe ist bevorzugt aus Weißglas gefertigt und weist einen Lichttransmissionsgrad TL von mindestens 90 % im sichtbaren Spektralbereich auf. Auch die Frontelektrode im Falle einer monofazialen photovoltaischen Zelle ist bevorzugt transparent mit einem Lichttransmissionsgrad von mindestens 80 %, besonders bevorzugt mindestens 90 %. Die äußere Zwischenschicht ist bevorzugt aus einer klaren thermoplastischen Folie, besonders bevorzugt aus einer klaren PVB-Folie, ausgebildet.

Die Erfindung umfasst weiter ein Verfahren zur Herstellung einer erfindungsgemäßen Verbundscheibe, wobei zumindest
a) ein Schichtstapel bereitgestellt wird, der in der folgenden Reihenfolge mindestens umfasst:
   - eine Außenscheibe mit einer Außenfläche und einer Innenfläche, wobei die Außenscheibe eine Glasscheibe mit einem geringen Eisenanteil ist,
   - eine äußere Zwischenschicht,
   - mindestens ein photovoltaisches Bauteil, wobei das mindestens eine photovoltaische Bauteil ein photovoltaisches Modul mit einer Mehrzahl miteinander verschalteter photovoltaischer Zellen und zwischen diesen photovoltaischen Zellen gebildeten Zellzwischenräumen ist,
   - eine innere Zwischenschicht, und
   - eine Innenscheibe mit einer Außenfläche und einer Innenfläche,
      wobei auf einer von der Außenscheibe abgewandten Seite des mindestens einen photovoltaischen Bauteils ein Diffusionselement vorgesehen wird, um von einer Außenseite durch die Außenscheibe eintretende und durch die Zellzwischenräume des photovoltaischen Moduls hindurchtretende Strahlung vor Eintritt in einen Innenraum diffus zu brechen, und
b) der Schichtstapel durch Lamination verbunden wird.

Die Lamination des Schichtstapels kann mittels geläufiger Laminationsverfahren erfolgen. Es können bspw. sogenannte Autoklavverfahren bei einem erhöhten Druck von etwa 10 bar bis 15 bar und Temperaturen von 130 °C bis 145 °C über etwa 2 Stunden durchgeführt werden. Alternativ sind auch autoklavfreie Verfahren möglich. An sich bekannte Vakuumsack- oder Vakuumringverfahren arbeiten bspw. bei etwa 200 mbar und 80 °C bis 110 °C. Der Schichtstapel kann auch in einem Kalander zwischen mindestens einem Walzenpaar zu einer Verbundscheibe verpresst werden. Anlagen dieser Art sind zur Herstellung von Verbundscheiben bekannt und verfügen normalerweise über mindestens einen Heiztunnel vor einem Presswerk. Die Temperatur während des Pressvorgangs beträgt bspw. von 40 °C bis 150 °C. Kombinationen von Kalander- und Autoklavverfahren haben sich in der Praxis besonders bewährt. Alternativ können Vakuumlaminatoren eingesetzt werden. Diese bestehen aus einer oder mehreren beheizbaren und evakuierbaren Kammern, in denen die Außenscheibe und die Innenscheibe innerhalb von bspw. etwa 60 Minuten bei verminderten Drücken von 0,01 mbar bis 800 mbar und Temperaturen von 80 °C bis 170 °C laminiert werden.

Vor dem oder beim Stapeln der Schichten für die Bereitstellung des Schichtstapels in Schritt a) wird das mindestens eine photovoltaische Bauteil mit den erforderlichen elektrischen Anschlüssen versehen, wobei sich elektrische Leiter über die Seitenkante des Schichtstapels hinaus erstrecken, mittels derer das mindestens eine photovoltaische Bauteil später elektrisch kontaktiert werden kann, bspw. zum Anschluss an ein elektrisches System, eine Batterie oder einen oder mehrere einzelne elektrische Verbraucher. Ist eine Mehrzahl von photovoltaischen Bauteilen vorhanden, so werden diese (zumindest gruppenweise) elektrisch miteinander verbunden und dadurch verschaltet, so dass alle photovoltaischen Bauteile (oder jede Gruppe von photovoltaischen Bauteilen) durch gemeinsame elektrische Leiter extern elektrisch kontaktiert werden können.

In einer Ausführungsform der Erfindung können die Außenscheibe und die Innenscheibe vor Schritt a) einem Biegeprozess unterzogen werden, um sie in eine zylindrisch oder sphärisch gebogene Form zu bringen, wie es für Scheiben zur Verwendung in Fahrzeugen üblich ist, insbesondere für Scheiben zur Verwendung in Personenkraftwagen oder Lastkraftwagen. Zum Biegen wird die Scheibe durch Erhitzen erweicht, so dass sie plastisch formbar wird, und dann durch an sich bekannte Methoden, bspw. Schwerkraftbiegen, Pressbiegen und/oder Saugbiegen, geformt. Typische Temperaturen für Glasbiegeprozesse betragen bspw. von 500 °C bis 700 °C.

In einer bevorzugten Ausführungsform der Erfindung werden die Außenscheibe und die Innenscheibe unter denselben Temperaturbedingungen gebogen. Dies ist besonders vorteilhaft, wenn sowohl die Außenscheibe als auch die Innenscheibe die Glasscheibe mit einem geringen Eisenanteil ist, und bevorzugt die Außenscheibe und die Innenscheibe dieselbe Glaszusammensetzung aufweisen. Insbesondere führt die Verwendung von Glasscheiben mit derselben Glaszusammensetzung zu einer Vereinfachung und hohen Flexibilität des Herstellungsprozesses, da die Glasscheiben für die Außenscheibe und die Innenscheibe leicht ausgetauscht und übereinstimmende Temperaturbedingungen für die Biegung der Glasscheiben gewählt werden können.

Die vorstehend im Zusammenhang mit der erfindungsgemäßen Verbundscheibe beschriebenen Ausführungsformen gelten in gleicher Weise auch für das erfindungsgemäße Verfahren.

Die Erfindung umfasst außerdem eine Verwendung einer erfindungsgemäßen Verbundscheibe als Fahrzeug-Dachscheibe, insbesondere als Dachscheibe eines Personenkraftwagens oder Lastkraftwagens.

Die verschiedenen Ausführungsformen der Erfindung können einzeln oder in beliebigen Kombinationen realisiert sein. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Generell sind "ein" und "eine" im Rahmen dieser Offenbarung als unbestimmte Artikel und damit ohne ausdrücklich gegenteilige Angabe immer auch als "mindestens ein" bzw. "mindestens eine" zu lesen.

Die Erfindung wird anhand von Zeichnungen und Ausführungsbeispielen näher erläutert. Die Zeichnungen sind schematische Darstellungen und nicht maßstabsgetreu. Die Zeichnungen schränken die Erfindung in keiner Weise ein. Es zeigen:
- Fig. 1: eine Draufsicht auf eine Ausgestaltung einer erfindungsgemäßen Verbundscheibe 100,
- Fig. 2: einen Querschnitt entlang X-X' durch die Verbundscheibe 100 aus Figur 1,
- Fig. 3-7: weitere Ausgestaltungen einer erfindungsgemäßen Verbundscheibe 100 in einer Querschnittsansicht entlang X-X', und
- Fig. 8: ein Ausführungsbeispiel eines erfindungsgemäßen Verfahrens anhand eines Flussdiagramms.

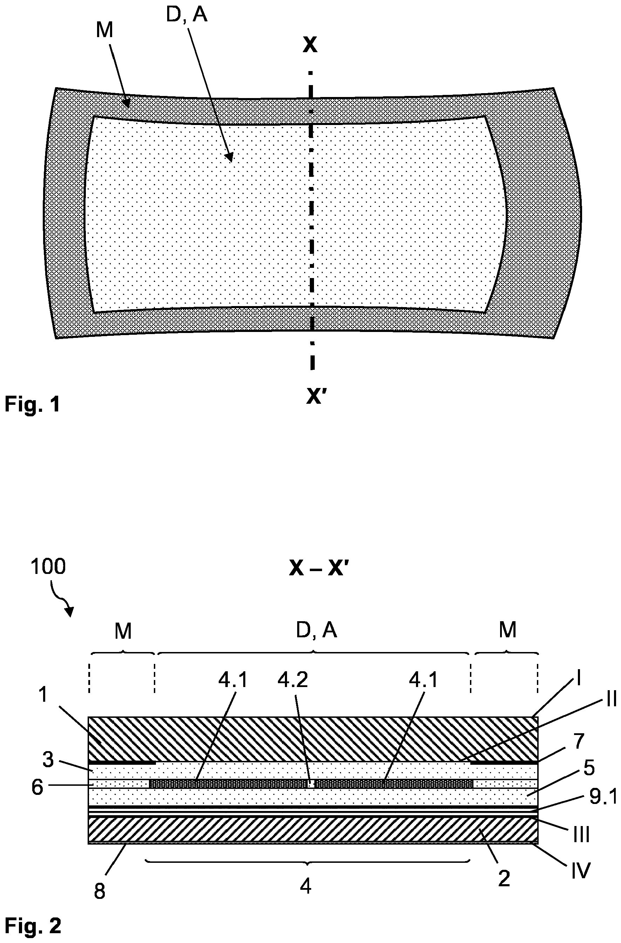

Figur 1 zeigt eine Draufsicht auf eine Verbundscheibe 100 gemäß einer erfindungsgemäßen Ausgestaltung. Im gezeigten Beispiel ist die Verbundscheibe 100 eine Fahrzeug-Dachscheibe. Diese Verbundscheibe 100 weist, von oben auf ein Fahrzeug (nicht dargestellt) gesehen, einen opaken Maskierungsbereich M auf, der umlaufend im Randbereich der Verbundscheibe 100 angeordnet ist und einen zentralen transparenten Durchsichtsbereich D (mit darin angeordnetem aktivem Bereich A) rahmenartig umgibt.

Figur 2 zeigt einen Querschnitt entlang einer Linie X-X' durch die Verbundscheibe 100 aus Figur 1. Wie in der Figur 2 dargestellt, umfasst die Verbundscheibe 100 in der folgenden Reihenfolge eine Außenscheibe 1 mit einer Außenfläche I und einer Innenfläche II, wobei die Außenscheibe 1 eine Glasscheibe mit einem geringen Eisenanteil darstellt, eine äußere Zwischenschicht 3, ein photovoltaisches Bauteil 4, eine innere Zwischenschicht 5 und eine Innenscheibe 2 mit einer Außenfläche III und einer Innenfläche IV, wobei die Innenscheibe 2 eine Glasscheibe darstellt. Ferner umfasst die Verbundscheibe 100 im gezeigten Beispiel eine emissivitätsmindernde Beschichtung 8, die auf der Innenseite IV der Innenscheibe 2 angeordnet ist.

Die Außenscheibe 1 ist eine Glasscheibe mit einem geringen Eisenanteil. Die Glasscheibe mit einem geringen Eisenanteil ist ein Kalk-Natron-Glas, wobei der Gesamteisenanteil, ausgedrückt in der Form von Fe₂O₃, 0,020 Gew.-% oder weniger, bezogen auf 100 Gew.-% der gesamten Glaszusammensetzung, beträgt und wobei der Fe²⁺-Anteil, ausgedrückt in der Form von FeO, 0,0030 Gew.-% oder weniger, bezogen auf 100 Gew.-% der gesamten Glaszusammensetzung, beträgt. Durch die Verwendung von Glas mit einem geringen Eisenanteil kann mehr Sonnenlicht die Außenscheibe 1passieren und auf das photovoltaische Bauteil 4 treffen, so dass dieses im Vergleich zu der Verwendung von Glas mit einem höheren Eisenanteil mehr elektrische Energie erzeugen kann.

Die Glasscheibe mit einem geringen Eisenanteil der Außenscheibe 1 weist einen Lichttransmissionsgrad TL von 90 % oder mehr auf, sodass möglichst viel Licht auf das photovoltaische Bauteil 4 treffen kann.

Die Außenscheibe 1 weist eine Dicke von 2,1 mm auf, die Innenscheibe 2 eine Dicke von 2,1 mm. Die Außenscheibe 1 ist in Einbaulage der äußeren Umgebung, die Innenscheibe 2 einem (Fahrzeug-)Innenraum zugewandt.

Die Außenscheibe 1 weist den opaken Maskierungsbereich M auf (siehe auch Figur 1). Im Maskierungsbereich M ist ein schwarzer Abdeckdruck 7 auf der Innenfläche II der Außenscheibe 1 aufgebracht. Der Durchsichtsbereich D definiert den aktiven Bereich A der Verbundscheibe 100, in dem elektrische Energie durch Photovoltaik gewonnen werden kann. Dazu ist das photovoltaische Bauteil 4 zwischen der Außenscheibe 1 und der Innenscheibe 2 angeordnet. In der gezeigten Ausführungsform deckt das photovoltaische Bauteil 4 den aktiven Bereich A vollständig ab und erstreckt sich von da aus bis in den Maskierungsbereich M hinein. Ein Überlappen von photovoltaischem Bauteil 4 und Maskierungsbereich M kann, bspw. aus Gestaltungsgründen, bevorzugt sein, ist jedoch nicht erforderlich. Bspw. kann auch (in der Draufsicht) ein Spalt zwischen photovoltaischem Bauteil 4 und Maskierungsbereich M bestehen. Die Lage mit dem photovoltaischen Bauteil 4 enthält eine thermoplastische Kapsellage 6, welche rahmenartig um eine Aussparung ausgebildet ist, in welcher das photovoltaische Bauteil 4 angeordnet ist.

Die über die Seitenkante der Verbundscheibe 100 hinausragenden elektrischen Anschlüsse des photovoltaischen Bauteils 4 sind der Einfachheit halber nicht dargestellt. Über diese Anschlüsse kann (im Falle der Verwendung als Fahrzeugverbundscheibe) das photovoltaische Bauteil 4 mit der Bordelektrik des Fahrzeugs verbunden werden, bspw. um die Fahrzeug-Batterie zu laden.

Die äußere Zwischenschicht 3 und die innere Zwischenschicht 5 sind jeweils aus einer klaren PVB-Folie mit einer Dicke von 0,76 mm ausgebildet. Dies bedeutet, dass die PVB-Folie nicht gefärbt ist und einen hohen Lichttransmissionsgrad TL aufweist. Durch die Verwendung der klaren PVB-Folie für die äußere Zwischenschicht kann mehr Licht die äußere Zwischenschicht passieren und auf das photovoltaische Bauteil 4 treffen, sodass dieses im Vergleich zur Verwendung von gefärbten PVB-Folien mehr elektrische Energie erzeugen kann. Zudem kann durch die Verwendung der klaren PVB-Folien für die innere Zwischenschicht mehr Licht in den (Fahrzeug-)Innenraum gelangen. Die thermoplastische Kapsellage 6 ist aus einer PVB-Folie mit einer Dicke von 0,38 mm ausgebildet, was ungefähr der Dicke des photovoltaischen Bauteils 4 entspricht.

Das photovoltaische Bauteil 4 umfasst ein photovoltaisches Modul mit einer Mehrzahl miteinander verschalteter photovoltaischer Zellen 4.1. Genauer gesagt umfasst das photovoltaische Modul eine Mehrzahl seriell miteinander verschalteter photovoltaischer Zellen 4.1, die in einem Strang angeordnet sind, der sich in eine Richtung erstreckt. Im gezeigten Beispiel sind die photovoltaischen Zellen 4.1 monofaziale photovoltaische Zellen 4.1. Die photovoltaischen Zellen 4.1 sind opak und weisen im gezeigten Beispiel einen Lichttransmissionsgrad TL für sichtbares Licht von weniger 5% auf. Zwischen jeweils benachbarten Zellen ist ein Zellzwischenraum 4.2 ausgebildet, welcher es ermöglicht, die für sich genommen ebenen photovoltaischen Zellen 4.1 in einer insgesamt gekrümmten Verbundscheibe anzuordnen. Im gezeigten Beispiel beträgt der als Zellzwischenraum 4.2 zwischen den photovoltaischen Zellen 4.1 sichtbare Abstand 1 cm.

Durch diesen Zellzwischenraum 4.2 fällt Licht auf ein auf einer von der Außenscheibe 1 abgewandten Seite des photovoltaischen Bauteils 4 vorgesehenes Diffusionselement 9.1. Das Diffusionselement 9.1 bricht das von der Außenseite durch die Außenscheibe 1 eintretende und durch die Zellzwischenräume 4.2 des photovoltaischen Moduls 4 hindurchtretendes Licht vor Eintritt in den Innenraum diffus. Im gezeigten Beispiel bedeckt das Diffusionselement 9.1 80 % der innerhalb des Durchsichtsbereichs D der Verbundscheibe 100 liegenden Zellzwischenräume 4.2. Zudem weist das Diffusionselement 9.1 zumindest im Bereich darüberliegender Zellzwischenräume 4.2 einen Lichttransmissionsgrad TL von 90 % und einen Haze von 10 % auf. Durch die beschriebene Abdeckung der Zellzwischenräume 4.2 mittels des Diffusionselements 9.1 wird die Bildung von Schattenmustern im Innenraum (zumindest im Bereich der abgedeckten Zellzwischenräume) vermieden, sodass in diesem Bereich der Komfort von Personen im Innenraum verbessert wird. Zudem werden durch den beschriebenen Lichttransmissionsgrad TL für die Personen im Innenraum angenehme Lichtverhältnisse geschaffen, da das von der Außenseite durch die Außenscheibe 1 einfallende und von dem Diffusionselement 9.1 gefilterte Licht letzteres größtenteils passiert und somit zur homogenen Ausleuchtung des Innenraums zur Verfügung steht.

In der in Figur 2 gezeigten Ausführungsform ist das Diffusionselement 9.1 an der Außenfläche III der Innenscheibe 2 als texturierte Oberfläche ausgebildet. Das Diffusionselement 9.1 ist also Bestandteil der Innenscheibe 2 und liegt (im fertig montierten Zustand der Verbundscheibe 100) zwischen der von der Außenscheibe 1 abgewandten Seite des photovoltaischen Bauteils 4 und der Innenfläche IV der Innenscheibe 2. Die Ausgestaltung des Diffusionselements 9.1 als Bestandteil der Innenscheibe 2 ermöglicht es, die Herstellung der texturierten Oberfläche bspw. in den Fertigungsprozess der Innenscheibe 2 zu integrieren, sodass die übrigen Schritte zur Herstellung der Verbundscheibe 100 hiervon unbeeinträchtigt bleiben. Zudem beseitigt die texturierte Oberfläche etwaige, vor ihrer Aufbringung an der Außenfläche III vorhandene Unregelmäßigkeiten, sodass auch Gläser mit geringeren Oberflächengüten in der erfindungsgemäßen Verbundscheibe 100 zum Einsatz kommen können. Zudem kann durch die Integration der texturierten Oberfläche in die Innenscheibe 2 deren Materialstärke unverändert bleiben, sodass eine derart gebildete Verbundscheibe 100 hinsichtlich Gesamtdicke und Gewicht vorteilhaft ist.

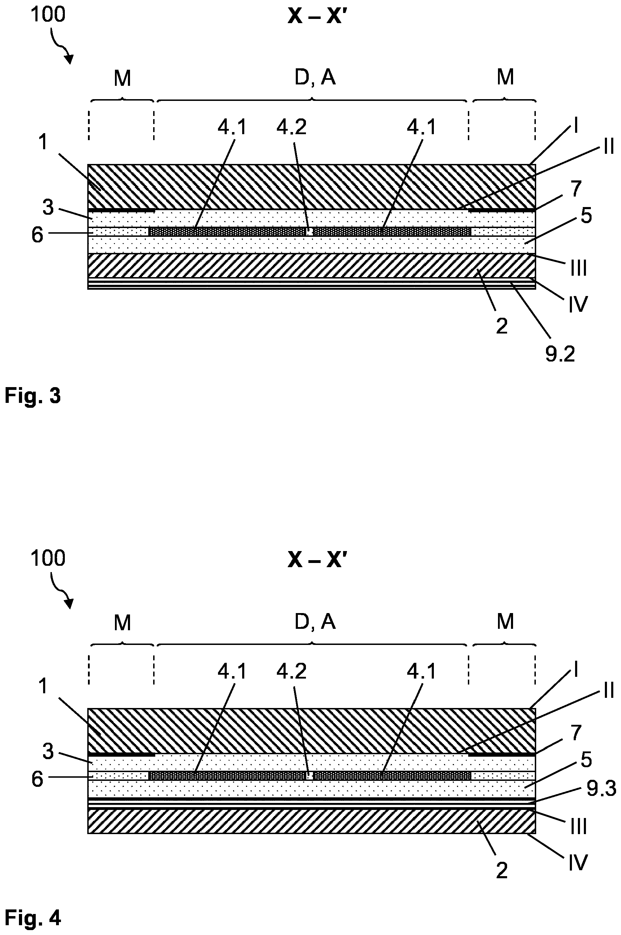

Figur 3 zeigt einen Querschnitt entlang der Linie X-X' durch eine weitere Ausgestaltung der erfindungsgemäßen Verbundscheibe 100. Sie unterscheidet sich von der vorstehenden Ausgestaltung der Figur 2 dadurch, dass das Diffusionselement 9.2 an der Innenfläche IV der Innenscheibe 2 als Aufbringschicht ausgebildet ist und (zur Vereinfachung der Darstellung) auf der Innenfläche IV der Innenscheibe 2 keine emissivitätsmindernde Beschichtung 8 vorgesehen ist. Die Ausgestaltung des Diffusionselements 9.2 als Aufbringschicht ermöglicht es, diese in den Fertigungsprozess der Innenscheibe 2 zu integrieren. Zudem ist die Verwendung der Aufbringschicht hinsichtlich des Gewichts der hieraus gebildeten Verbundscheibe 100 vorteilhaft.

Figur 4 zeigt einen Querschnitt entlang der Linie X-X' durch eine weitere Ausgestaltung der erfindungsgemäßen Verbundscheibe 100. Sie unterscheidet sich von der Ausgestaltung der Figur 2 dadurch, dass das Diffusionselement 9.3 eine diffusive Folie ist, welche zwischen der inneren Zwischenschicht 5 und der Außenfläche III der Innenscheibe 2 angeordnet ist. Zudem ist (zur Vereinfachung der Darstellung) auf der Innenfläche IV der Innenscheibe 2 keine emissivitätsmindernde Beschichtung 8 vorgesehen. Die Ausgestaltung des Diffusionselements 9.3 als Folie ermöglicht es, diese im Laminationsverfahren zwischen der inneren Zwischenschicht 5 und der Außenfläche III der Innenscheibe 2 anzuordnen und mit diesen zu verbinden. Hierdurch kann zuverlässig eine flächige Verbindung zwischen der Folie und den die Folie umgebenden Schichten hergestellt und zudem bspw. die mechanische Stabilität des Schichtaufbaus verbessert werden.

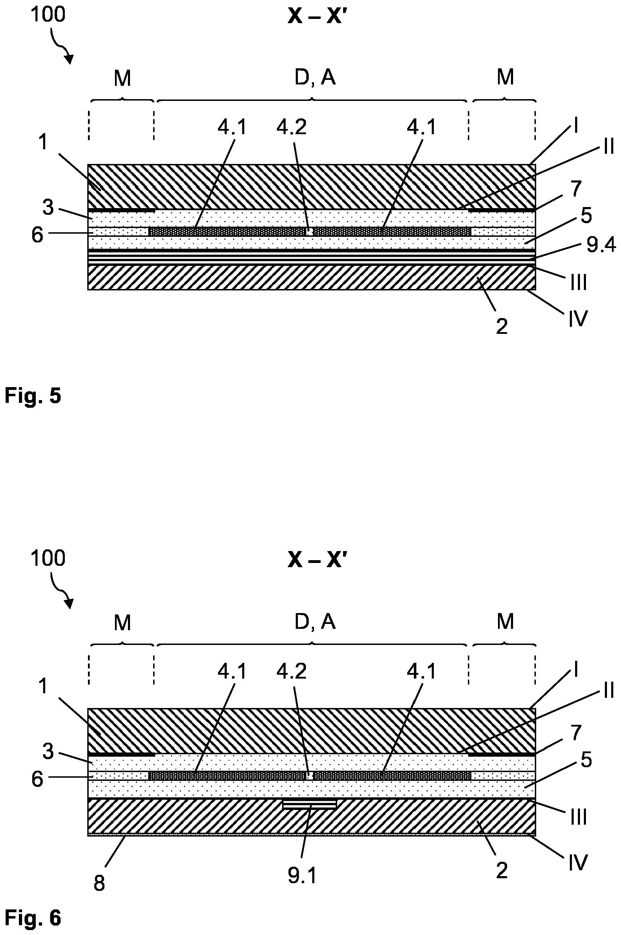

Figur 5 zeigt einen Querschnitt entlang der Linie X-X' durch eine weitere Ausgestaltung der erfindungsgemäßen Verbundscheibe 100. Sie unterscheidet sich von der Ausgestaltung der Figur 2 dadurch, dass das Diffusionselement 9.4 eine diffusive Folie ist, welche als Zweischichtfolie integral mit der inneren Zwischenschicht 5 gebildet ist. Zudem ist (zur Vereinfachung der Darstellung) auf der Innenfläche IV der Innenscheibe 2 keine emissivitätsmindernde Beschichtung 8 vorgesehen. Die Integration von diffusiver Folie und innerer Zwischenschicht 5 in der Zweischichtfolie erhöht deren mechanische Stabilität (insbesondere im bevorzugten Fall einer inneren Zwischenschicht 5 aus EVA) und ermöglicht es zudem, die Einbringung des Diffusionselements 9.4 fertigungstechnisch in einen Verfahrensschritt mit der Herstellung des photovoltaischen Bauteils 4 zu integrieren. Hierdurch wird die Herstellung der Verbundscheibe 100 vereinfacht und es kann eine verbesserte mechanische Stabilität der Verbundscheibe 100 erreicht werden.

Figur 6 zeigt einen Querschnitt entlang der Linie X-X' durch eine weitere Ausgestaltung der erfindungsgemäßen Verbundscheibe 100. Sie unterscheidet sich von der Ausgestaltung der Figur 2 dadurch, dass nur im Bereich unterhalb des Zellzwischenraums 4.2 das Diffusionselement 9.1 als texturierte Oberfläche vorgesehen ist. Eine abschnittsweise Anordnung kann die Gestaltungsflexibilität der Verbundscheibe 100 erhöhen und den für deren Herstellung erforderlichen Aufwand (und die zugehörigen Kosten) senken.

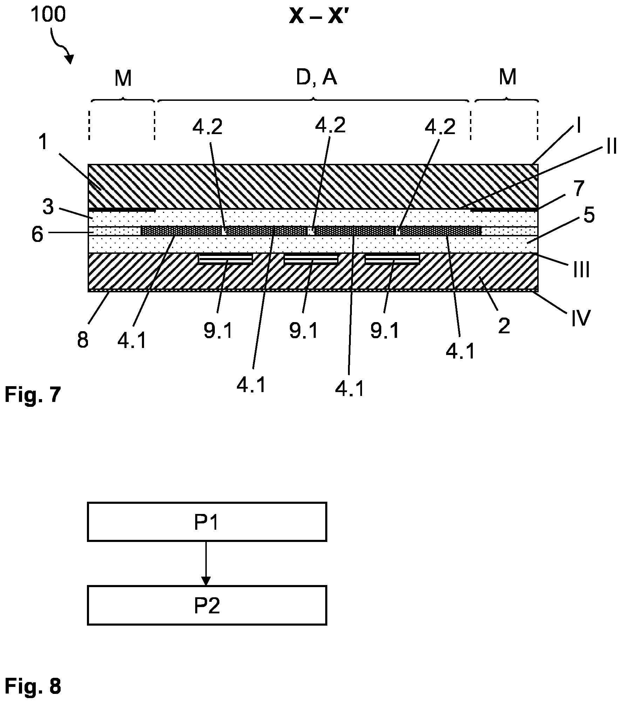

Figur 7 zeigt einen Querschnitt entlang der Linie X-X' durch eine weitere Ausgestaltung der erfindungsgemäßen Verbundscheibe 100. Sie unterscheidet sich von der Ausgestaltung der Figur 2 dadurch, dass mehrere Zellzwischenräume 4.2 gebildet und jeweils nur im Bereich unterhalb dieser die Diffusionselemente 9.1 als texturierte Oberfläche vorgesehen sind. Eine abschnittsweise Anordnung unter mehreren Zellzwischenräumen 4.2 kann die Gestaltungsflexibilität der Verbundscheibe 100 weiter erhöhen.

Figur 8 zeigt ein Ausführungsbeispiel des erfindungsgemäßen Verfahrens zur Herstellung einer erfindungsgemäßen Verbundscheibe 100 anhand eines Flussdiagramms, wobei zumindest in
P1 ein Schichtstapel bereitgestellt wird, der in der folgenden Reihenfolge mindestens umfasst:
   - eine Außenscheibe 1 mit einer Außenfläche und einer Innenfläche I, II, wobei die Außenscheibe 1 eine Glasscheibe mit einem geringen Eisenanteil ist,
   - eine äußere Zwischenschicht 3,
   - ein photovoltaisches Bauteil 4, wobei das photovoltaische Bauteil 4 ein photovoltaisches Modul mit einer Mehrzahl miteinander verschalteter photovoltaischer Zellen 4.1 und zwischen diesen photovoltaischen Zellen 4.1 gebildeten Zellzwischenräumen 4.2 ist,
   - eine innere Zwischenschicht 5, und
   - eine Innenscheibe 2 mit einer Außenfläche und einer Innenfläche III, IV,

   wobei auf einer von der Außenscheibe 1 abgewandten Seite des photovoltaischen Bauteils 4 ein Diffusionselement 9.1, 9.2, 9.3, 9.4 vorgesehen wird, um von einer Außenseite durch
   die Außenscheibe 1 eintretende und durch die Zellzwischenräume 4.2 des photovoltaischen Moduls 4 hindurchtretende Strahlung vor Eintritt in einen Innenraum diffus zu brechen, und
P2 der Schichtstapel durch Lamination verbunden wird.

### Bezugszeichenliste

- 1: Außenscheibe
- 2: Innenscheibe
- 3: äußere Zwischenschicht
- 4: photovoltaisches Bauteil
- 4.1: photovoltaische Zelle
- 4.2: Zellzwischenraum
- 5: innere Zwischenschicht
- 6: thermoplastische Kapsellage
- 7: Abdeckdruck
- 8: emissivitätsmindernde Beschichtung (LowE-Beschichtung)
- 9.1: Diffusionselement (erste Ausgestaltung)
- 9.2: Diffusionselement (zweite Ausgestaltung)
- 9.3: Diffusionselement (dritte Ausgestaltung)
- 9.4: Diffusionselement (vierte Ausgestaltung)

- 100: Verbundscheibe

- I: Außenfläche der Außenscheibe 1
- II: Innenfläche der Außenscheibe 1
- III: Außenfläche der Innenscheibe 2
- IV: Innenfläche der Innenscheibe 2

- D: Durchsichtsbereich der Außenscheibe 1
- M: Maskierungsbereich der Außenscheibe 1
- A: aktiver Bereich der Verbundscheibe 100

- X-X': Schnittlinie

## Patentansprüche

1. Verbundscheibe (100) zur Reduktion einer Schattenbildung in einem Innenraum, mindestens umfassend in der folgenden Reihenfolge:
- eine Außenscheibe (1) mit einer Außenfläche und einer Innenfläche (I, II), wobei die Außenscheibe (1) eine Glasscheibe mit einem geringen Eisenanteil ist,
- eine äußere Zwischenschicht (3),
- mindestens ein photovoltaisches Bauteil (4), wobei das mindestens eine photovoltaische Bauteil (4) ein photovoltaisches Modul mit einer Mehrzahl miteinander verschalteter photovoltaischer Zellen (4.1) und zwischen diesen photovoltaischen Zellen (4.1) gebildeten Zellzwischenräumen (4.2) ist,
- eine innere Zwischenschicht (5), und
- eine Innenscheibe (2) mit einer Außenfläche und einer Innenfläche (III, IV),
wobei auf einer von der Außenscheibe (1) abgewandten Seite des mindestens einen photovoltaischen Bauteils (4) ein Diffusionselement (9.1, 9.2, 9.3, 9.4) vorgesehen ist, welches von einer Außenseite durch die Außenscheibe (1) eintretende und durch die Zellzwischenräume (4.2) des photovoltaischen Moduls hindurchtretende Strahlung vor Eintritt in den Innenraum diffus bricht.

2. Verbundscheibe (100) nach Anspruch 1, wobei das Diffusionselement (9.1, 9.2, 9.3, 9.4) mindestens 80 % der innerhalb eines Durchsichtsbereichs (D) der Verbundscheibe (100) liegenden Zellzwischenräume (4.2) abdeckt.

3. Verbundscheibe (100) nach Anspruch 1 oder 2, wobei das Diffusionselement (9.1, 9.2, 9.3, 9.4) zumindest im Bereich darüberliegender Zellzwischenräume (4.2) einen Lichttransmissionsgrad TL von 90 % oder mehr aufweist.

4. Verbundscheibe (100) nach einem der Ansprüche 1 bis 3, wobei das Diffusionselement (9.1, 9.2, 9.3, 9.4) zumindest im Bereich darüberliegender Zellzwischenräume (4.2) einen Haze von 10 % oder mehr aufweist.

5. Verbundscheibe (100) nach einem der Ansprüche 1 bis 4, wobei die äußere Zwischenschicht (3) und die innere Zwischenschicht (5) aus einer klaren thermoplastischen Folie ausgebildet sind.

6. Verbundscheibe (100) nach einem der Ansprüche 1 bis 4, wobei die äußere Zwischenschicht aus einer klaren thermoplastischen Folie ausgebildet ist und die innere Zwischenschicht aus einer gefärbten thermoplastischen Folie ausgebildet ist.

7. Verbundscheibe (100) nach einem der Ansprüche 1 bis 6, wobei das Diffusionselement (9.1) an der Außenfläche (III) und/oder der Innenfläche (IV) der Innenscheibe (2) als texturierte Oberfläche der Außenfläche bzw. der Innenfläche (III, IV) ausgebildet ist.

8. Verbundscheibe (100) nach einem der Ansprüche 1 bis 6, wobei das Diffusionselement (9.2) an der Außenfläche (III) und/oder der Innenfläche (IV) der Innenscheibe (2) als Aufbringschicht ausgebildet ist.

9. Verbundscheibe (100) nach einem der Ansprüche 1 bis 6, wobei das Diffusionselement (9.3) eine diffusive Folie ist, welche zwischen der inneren Zwischenschicht (5) und der Außenfläche (III) der Innenscheibe (2) angeordnet ist.

10. Verbundscheibe (100) nach einem der Ansprüche 1 bis 6, wobei das Diffusionselement (9.4) eine diffusive Folie ist, welche als Zweischichtfolie integral mit der inneren Zwischenschicht (5) gebildet ist.

11. Verbundscheibe (100) nach Anspruch 9 oder 10, wobei die diffusive Folie ferner diffraktive Bereiche aufweist.

12. Verbundscheibe (100) nach einem der Ansprüche 1 bis 11, wobei die Verbundscheibe (100) weiter eine emissivitätsmindernde Beschichtung (8) umfasst, die auf der Innenfläche (IV) der Innenscheibe (2) angeordnet ist.

13. Verfahren zur Herstellung einer Verbundscheibe (100), insbesondere einer nach einem der Ansprüche 1 bis 12, wobei zumindest
a) ein Schichtstapel bereitgestellt wird, der in der folgenden Reihenfolge mindestens umfasst:
- eine Außenscheibe (1) mit einer Außenfläche und einer Innenfläche (I, II), wobei die Außenscheibe (1) eine Glasscheibe mit einem geringen Eisenanteil ist,
- eine äußere Zwischenschicht (3),
- mindestens ein photovoltaisches Bauteil (4), wobei das mindestens eine photovoltaische Bauteil (4) ein photovoltaisches Modul mit einer Mehrzahl miteinander verschalteter photovoltaischer Zellen (4.1) und zwischen diesen photovoltaischen Zellen (4.1) gebildeten Zellzwischenräumen (4.2) ist,
- eine innere Zwischenschicht (5), und
- eine Innenscheibe (2) mit einer Außenfläche und einer Innenfläche (III, IV), wobei auf einer von der Außenscheibe (1) abgewandten Seite des mindestens einen photovoltaischen Bauteils (4) ein Diffusionselement (9.1, 9.2, 9.3, 9.4) vorgesehen wird, welches von einer Außenseite durch die Außenscheibe (1) eintretende und durch die Zellzwischenräume (4.2) des photovoltaischen Moduls hindurchtretende Strahlung vor Eintritt in einen Innenraum diffus bricht, und
b) der Schichtstapel durch Lamination verbunden wird.

14. Verfahren zur Herstellung einer Verbundscheibe (100) nach Anspruch 13, wobei vor Schritt a) die Außenscheibe (1) und die Innenscheibe (2) einem Biegeschritt unterzogen werden, wobei die Außenscheibe (1) und die Innenscheibe (2) unter denselben Temperaturbedingungen gebogen werden.

15. Verwendung einer Verbundscheibe (100) nach einem der Ansprüche 1 bis 12 als Fahrzeug-Dachscheibe.
